# EUROPEAN PATENT SPECIFICATION

(11) **EP 3 704 722 B1**
(45) Date of publication and mention of the grant of the patent: **13.09.2023**
(21) Application number: 18839673.3
(22) Date of filing: 30.10.2018
(51) Int. Cl.: H01B 13/012, F03D 80/80

(54) **ELECTRIC WIRE HARNESS**
ELEKTRISCHER KABELBAUM
FAISCEAU DE CONDUCTEURS

(30) Priority: 31.10.2017 DK PA201770815
(43) Date of publication of application: 09.09.2020
(73) Proprietor: KK Wind Solutions A/S, 7430 Ikast (DK)
(72) Inventor: MUÑOZ PEREA, Mario Alberto, 7400 Herning (DK)
(74) Representative: Patentgruppen A/S
(86) International application number: PCT/DK2018/050275
(87) International publication number: WO 2019/086090

(56) References cited:
- EP-A1- 0 709 252
- EP-A2- 2 575 147
- FR-A1- 2 799 879
- FR-A1- 3 005 375
- GB-A- 2 068 786
- JP-A- 2017 004 757
- US-A- 5 895 889

## Description

### Field of the invention

The invention relates to an electric wire harness, electrical panel assembly and method of mounting an electric wire harness in an electrical panel.

### Background of the invention

A modern electrical panel is normally arranged in a protective cabinet with access doors. The electrical panel forms an inner board in the cabinet for the electrical panel equipment such as terminal blocks, rows of electric components and wire ducts. The cabinet provides access to power supply and axillary circuits for the electrical panel and especially the access doors are often used for providing information and control over the functionality of the electrical panel.

The necessary wiring of the electrical panel and the cabinet including access doors and axillary circuits is extensive and involves numerous wires of different lengths and types.

Different guidance means are used by work persons in securing a correct wiring and assembly of the electrical panel such as electrical wire diagrams for identifying and positioning the electrical panel equipment and wires and marking tags and colors for numbering and labelling of the equipment and wires.

Electric wire harnesses are also used in wiring of electrical panels as a way of simplifying the manufacturing of the electrical panel. An electric wire harnesses comprises a bundle of wires for an electrical panel wherein the wires may have been prepared by automatic machinery in the correct lengths and types for the subsequent mounting in the electrical panel as an electric wire harness by the work persons. An example of such wire harness is provided in prior art document GB2068786 where electrical leads transversely are successively secured with tape. Another prior art US 5 895 889 A discloses a wire harness corresponding to the preamble of claim 1.

However, the manufacturing of the electrical panel is still a complex and time-consuming process with many possibilities for the work persons of making errors in the wiring and assembly of the electrical panel.

The use of automatic machinery for also performing the manufacturing of electrical panels e.g. using prepared electric wire harnesses is also a known possibility in reducing wiring errors. However, the automatic machinery is expensive and difficult to reprogram which is a problem unless the automatic machinery is used in manufacturing very large series of identical electrical panels.

Electrical panels may be used in numerous industrial and commercial applications such as electrical control panels in wind turbines.

It is an object of the invention to provide an electric wire harness which is easy to use in assembling an electrical panel leading to less wiring errors and faster assembly of the electrical panel.

### Summary of the invention

According to a first aspect, the invention relates to an electric wire harness established based on an electric wire layout of an electric panel prepared for connecting electrical panel equipment of said electrical panel, the wire harness comprising: a plurality of electric wires of different dimensions having first and second wire ends, and a connector with locations for fastening and storage of a plurality of said first wire ends, where the locations of said first wire ends in said connector match the final locations of said first wire ends in the electrical panel wherein the electric wire harness is characterized in that the connector is a dummy connector with terminals for temporary connection and storage of a plurality of said first wire ends, and in that the sequence of the wires in the connector is determined by the electric wire layout of the electric panel.

Such wire harness is advantageous in that it at least has the following effects: an intuitive assembly process reducing requirements to qualification of the work person assembling is achieved, risk of human errors such as wrong mounting of a wire are minimised, the assembly and thereby speed of production of the panel is increased, the amount of scrap is reduced, optimised control of production in that it is possible to produce exactly the number of harnesses than is needed for the electric panel and do not have any additional wires or harnesses on stock, etc.

The wire harness can be used in wirings from a top / bottom terminal of the electrical panel to panel equipment and internal between panel equipment. The top / bottom terminal is normally the terminals to which external cables or wires are mounted to enable the panel equipment to communicate and control its surroundings e.g. in a control system of a wind turbine

By connection of the wire ends in the location of the connector ensures fixation of the wire ends so that they do not move afterwards e.g. during transportation. Preferably, the location of the connector are galvanic separated, so electric current cannot be conducted from one wire to another wire in the wire harness.

According to an embodiment of the invention, the electric wire harness is equipped with a tag linking the sequence of wires in the connector to a digital electric layout of the electrical panel.

Preferably, the tag is a data matrix label, that is produced based on the same data that is used by the machinery producing the wire harness.

This is advantageous in that it has the effect, that not only can the wire harness be automatic created based on the digital electric layout on a suitable machinery, but after creation each individual wire harness of a wire set of an electric panel can also be found in a computer device storing details of at least the electric layout of the electric panel. In this way by scanning the tag, the work person can be guided wire by wire through the mounting of the electric panel. This is advantageous in that not training is then required for the work person which is important at mounting sites where substitution of work persons happens frequently without slowing down production / panel mounting.

According to an embodiment of the invention, the connector is a flexible band comprising a first and a second side, wherein at least part of the length of either the first or second sides is adhesive and wherein the adhesive part define the locations for fastening and storing the plurality of said first wire ends.

The adhesive part is advantageous in that it has the effect, that wires can be fastened to the flexible band no matter dimensions of the wires i.e. a uniform connector can be used independent of wire types of the harness. The entire length of at least one side of the flexible band may be adhesive, however to reduce use of adhesive material only parts of the flexible band used as wire locations are provided with adhesive material

According to an embodiment of the invention, the connector is a flexible band comprising a first sheet and a second sheet, wherein the locations for fastening and storing the plurality of said first wire ends are established between the first sheet and second sheet.

This is advantageous in that it has the effect, that the connector is very flexible in terms of length (which can be from a few centimetres to several meters), distance between wires (which can be varied depending on type and dimensions of the wires) and dimensions / type of wires which can be located in the connector.

Further, the band type connectors are advantageous in that they have the effect, that they can be discharged after use i.e. logistics in collecting used connectors as well as inspection of used connectors before reuse is avoided.

Further, this is advantageous in two sheets together fix the wires at their locations during transport of the wire harness.

According to an embodiment of the invention, the connector is a flexible band and the part between to subsequent locations of the flexible band is between 0.5 centimeters and 5 centimeters, preferably 2 centimeters and wherein this part of the flexible band is none-adhesive.

This is advantageous in that handling the wire harness is simpler and more convenient when there is no adhesive part. The none-adhesive part may be established by connecting two sheets of the flexible band. Hence, also in the embodiment where both sheets of the flexible band have an adhesive side providing the wire locations therebetween both sides of the flexible band are none-adhesive. The is defined from center of the location and thereby of the wire.

The adhesive or glue is preferably part of a standard of the shelf tape which today is provided by a variety of different manufactures.

It should be mentioned that a reference to a dummy connector in this document includes a reference to a connector made of a flexible band hence flexible band may be replaced by dummy connector. Similarly, a reference to terminals includes a reference to the locations / positions of the flexible band holding the wires and again the term location / position can replace the term terminal.

A dummy connector with terminals for temporary connection and storage of a plurality of said first wire ends is advantage in that it allows an intuitive assembly process of the wire harness in the electrical panel in that connectors or wires ends hereof can be mounted directly one by one from its location in the connector to its location in the electrical panel equipment.

The use of a dummy connector is advantages in that it has the effect that it enables an atomised production of the wire harness in that at least all first wire ends are fixed in the dummy connector thereby serves as a fixation of the first wire ends. When the first wire ends are fixed (not necessarily in a connector) the length can be metered, and the wire cut in the needed length by a machinery adapted hereto. Such adaption at least incudes that the machinery is provided with diagrams of the panel layout.

How and in which sequence the machinery meters the length of the wires and connects the relevant wire ends to the connector do not reduce or eliminates any of the effects mentioned in relation to the present invention.

The dummy connector can be seen as a simple tool facilitating automated manufacturing of the wire harness. This is opposite to a permanent connector which is part of the wire harness also when mounted in the electrical panel.

According to an embodiment of the invention, the different dimensions of said electric wires include wire length, wire diameter, wire colour and/or wire type. This is advantages in that it has the effect that the wires harnesses are not limited to only include one type of wire. Thereby it is possible to product a wire harness including wires e.g. suitable for conducting different levels of voltage and current and data wires. Typically, wires carrying ground potential is coloured different from the rest of the wires. Typically, wires conducting current measured in milliamp are smaller in diameter (cross section) than wires conducting current measured in amps. The wires will typically have a diameter of up to 6 square millimeters and a length of up to 10 meters. The dimensions and locations are determined by the panel design.

According to an embodiment of the invention, said wire harness comprises one or more further dummy connectors with terminals for temporary connection and storage of a plurality of said second wire ends. This is advantage in that as with the first wire ends then also the second wire ends are fixed in a connector which ensures a predetermined position of the wire ends both during and after transportation of the wire harness.

According to an embodiment of the invention, the locations of said second wire ends in said further dummy connectors match the final locations of said second wire ends in the electrical panel equipment. As with the predetermined position of the first wire end the predetermined position of the second wire end is advantage in that it has the effect that the mounting of the second wire ends at the panel equipment are as easy and intuitive as mounting the first wire ends at the top terminals.

According to an embodiment of the invention, said harness comprises one or more permanent connectors for permanent connection of a plurality of said first wire ends or said second wire ends.

Permanent connectors are advantages in that it has the effect of enabling a 100% automated panel production. Hence if all first and second wire ends of a wire harness are terminated in a permanent connector by the machinery producing the wire harness, they are in condition for being mounted by a robotic arm. This of course require that the panel equipment is also equipped with connects (opposite sex to the connectors of the wire harness). Hence, a so-called plug and play solution for assembling an electrical panel is achieved.

According to an embodiment of the invention, said wire harness when produced and before mounting in the electrical panel is temporary attached to and stored at a hanger. This is advantageous in that it has the effect that the wire harness can be transported from the wire harness manufacturing site to electrical panel assembly site in a predetermined location. The predetermined location on the hanger is determined by the location of the wires of the wire harness in the electrical panel.

According to an embodiment of the invention, the wire harness is attached to the hanger by a connector hereof and the location of this connector at the hanger is determined by the sequence in which the wire harness is to be mounted in the electric panel.

This is advantageous in that it has the effect that if a plurality of different wire harnesses is needed to assemble one electrical panel, they can be temporary stored at the hanger in the sequence that they should be mounted in the electrical panel. Further, this also ease transportation between machinery producing the wire harness and the assembly station where the electrical panel is mounted in that the order of the wire harnesses are not messed up.

Preferably the hanger has wheels to ease transportation of the wire harnesses. Preferably the hanger is longer than the longest wire in a wire harness so that the temporary storage at the hanger takes up as little space as possible on the ground.

The type of hanger is not important i.e. tables, baskets etc. can be used however it is always preferred that the hanger comprise means for temporary mounting the connectors in a sequence determined by the panel design.

This is advantage in that the sequence of when to mount the dummy and further dummy connectors are determined based on the location at the connector frame. Thereby the sequence of the mounting can be planed prior to the mounting and thereby carried out in the most effective way. Effective should here be understood as including both time consumed on the mounting and reduction of risk erroneous mounting by a work person.

According to an embodiment of the invention, the wire harness is part of a wire set which also comprise single wires and wire bundles. A wire set is understood as including all wires needed for assembly of an electric panel. Dividing a wire set into one or more wire harnesses, wire bundles and single wires are advantageous in that it has the effect that wiring any panel layout is possible by means of one wire set. It should be mentioned, that if the electrical panel is very large, the individual parts (wire harness, wire bundles and single wires) can be temporary stored at more than one hanger.

According to an embodiment of the invention, said connectors of the wire harness prior to mounting in the panel are temporary attached to and stored at a connector fixture. This is advantage in that it has the effect that prior to mounting of the wire harness comprising e.g. dummy connectors and further dummy connectors in the electric panel, the connector fixture can be mounted e.g. to a robotic arm of a panel assembly station right next to the location of the panel where the wire ends have to be mounted. Thereby the distance between the connector and the terminal or panel equipment is reduced and maintained so that while mounting a first wire the second wire does not move and remains in a position ready for mounting next.

According to an embodiment of the invention, the first wire ends of a plurality of wires of said wire harness are connected to a first of said connectors, and wherein the second wire ends of the plurality of wires of said wire harness are connected to a second of said connectors, wherein an electric connection is established between a first and a second panel equipment when the first and second connectors are mounted to the first and second panel equipment.

Panel equipment here should be understood as also including the top terminals. Hence, when all wire ends of a wire harness are terminated in connectors mounting of the electric panel only requires connecting these connectors to opposite sex connectors of the electric panel equipment. This is at least true when the connectors are permanent connectors (i.e. not a dummy connector). When the connectors are permanent, then automated mounting e.g. by an electric controllable robotic arm can be performed.

According to an embodiment of the invention, said harness is used in wiring an electrical panel for a wind turbine such as an electrical wind turbine control panel.

According to a second aspect the invention relates to an electrical panel assembly for assembling an electrical panel, according to claim 5, said assembly comprising: an assembly table or fixture for holding the electrical panel, at least one electrical panel mounted in said assembly table or fixture where said panel includes electrical panel equipment such as terminal blocks, rows of electric components and wire ducts, at least one electric wire harness wherein the electric wire harness is prepared for connecting electrical panel equipment of an electrical panel, the wire harness comprising: a plurality of electric wires of different dimensions having first and second wire ends, and a connector with locations for fastening and storage of a plurality of said first wire ends, where the locations of said first wire ends in said connector match the final locations of said first wire ends in the electrical panel, for mounting in and wiring said electrical panel by at least one work person, and wherein said assembly further comprises a screen displaying or guiding the work person to where the wire ends of the wire harness should be mounted in the electrical panel.

This is advantage in that it has the effect that if the work person is in doubt of the mounting of a wire or connector, a diagram of the panel layout is available instantly and hence no significantly delay in the assembly time of the electrical panel is introduced if consulting the diagram is necessary.

The assembly station may be part of or temporary connected to the assembly table or fixture. Alternatively, it may be part of a trolley, table or hanger located next to the assembly table or fixture.

According to an embodiment of the invention, the assembly further comprises a computer device facilitating communication with a data storage and a scanner, wherein the data storage is storing a plurality of electric wire layouts of the electric panel, wherein the electric wire layout in the computer device is linked to unique tag information, and wherein the displaying or guiding on the screen is established by the computer device facilitating matching received tag information from the scanner upon scanning a tag physically linked to the wire harness, with an electric wire layout from the data storage.

According to an embodiment of the invention, the displaying on the screen facilitates guiding a work person wire by wire through the mounting of the wire harness in the electric panel, wherein the routing of the subsequent wire is displayed after the work person has provided input to the computer device or a determined time has passed.

A work person input may be scanning a so-called next wire tag, clicking a bottom (by hand or foot), speaking out a word such as next or done or by other means interacting with the computer device. The computer device may also be programmed to illustrate the subsequent wire routing after a certain time which is defined based on experiments made of mounting wire harnesses. Such time obviously is not necessarily the same between two subsequent wires but may depend on routing of the wire in the electric panel.

According to an embodiment of the invention, the at least one assembly station comprises an arm for holding at least one of the connectors of said electric wire harness, where said at least one connector is movable by use of the arm in relation to said electrical panel equipment of the electrical panel to establish a visual aligned relation for said work person between said at least one connector and at least one of said equipment.

This is advantage in that it has the effect that mounting of wires to the panel equipment can be made fast and intuitive. Further, the work person only has to move the wires from a predetermined location in the dummy connector of the wire harness to a matching predetermined location at the electrical panel equipment which reducing the likelihood of mounting errors.

According to an embodiment of the invention, said arm is a robotic arm with a gripping device at one end for holding said at least one connector and arm joints allowing rotational and/or translational displacement of the one end of said arm holding said at least one connector.

Preferably the robotic arm is manual movable but could also be used by an electric controller. The robotic arm is advantageous in that it has the effect that it allows the work person to locate the connector holding the wires to be moved at any desired location.

According to an embodiment of the invention, said gripping device is configured for holding a connector fixture, where the connector fixture is configured for holding a plurality of connectors. The connector fixture is advantageous in that it has the effect that holding one or more connectors by the gripping device of the arm is easy and possible in any determined sequence.

According to an embodiment of the invention, said assembly further comprises a robot configured for picking up a connector from the connector fixture and mounting the connector at a determined panel equipment. Allowing a robot to pick up and mount a connector is advantage in that it has the effect that every cycle of the robot is repeated with a very high precision. Thereby, a panel is assembled with a minimum of errors. Further, a robot has the effect that testing of the electric and mechanical connections are possible to perform as the connectors are mounted.

Accordingly, all permanent connectors of a wire harness are possible to mount by an electric controllable robotic arm. Hence, if all wire ends of a wire set is terminated in permanent connectors the degree of automatization of the assembly of the electric panel can be increased significantly.

According to an embodiment of the invention, the at least one assembly station comprises an arm for holding at least one of the connectors of said electric wire harness where said arm comprise a plurality of fingers facilitating holding the connector and thereby the wires of the wire harness in a predetermined position

This is advantageous in that it has the effect, that the wires of the wire harness is accessible to the work person in the sequence the work person needs the wire to mount it. The position of the wire harness fixed or hold by the is preferably vertical in that it requires a minimum of foot print. It may also be horizontal or with a fixed or variable inclination to facilitate the optimal work position for the work person. This way of storing the wire harness is further advantageous in that it establishes a visual aligned relation for the work person between the connector / wires and the panel

According to a third aspect, the invention relates to a method for assembling an electrical panel including electrical panel equipment, said method comprising the steps of: locating first wire ends of an electric wire harness in a connector in locations matching the final locations of said first wire ends in the electrical panel wherein the electric wire harness is prepared for connecting electrical panel equipment of an electrical panel, the wire harness comprising: a plurality of electric wires of different dimensions having first and second wire ends, and a connector with locations for fastening and storage of a plurality of said first wire ends,
where the locations of said first wire ends in said connector match the final locations of said first wire ends in the electrical panel, mounting the electrical panel in an electrical panel assembly, removing a first end of a first wire from a first location of the connector, mounting the first end of the first wire in the matching terminal of the electrical panel,
mounting a second end of the first wire in the electrical panel, and mounting the further wire ends of the electric wire harness in the electrical panel.

According to an embodiment of the invention, the electric wire harness is created by locating the first wire ends between a first sheet and a second sheet of a flexible band, wherein the first sheet and the second sheet are attached to each other between the locations of the first wire ends along the length of the flexible band.

This is advantageous in that an (in theory) endlessly long connector can be created and thereby the flexibility of the entire wire set for the electric panel can be increased. This flexibility includes number and dimensions of wires in one harness and the number of harnesses in one wire set may be reduced leading to less logistics.

The sequence of the wires in the connector / flexible band is determined by electric layouts / drawings of the electric panel.

According to an embodiment of the invention, the first wire ends are spaced apart with at least 0.5 centimetres, preferably at least 2 centimetres along the length of the flexible band. This is advantageous in that fixation of wires at their locations in the flexible band (also referred to as dummy connector) are fixed with at least 0.5 centimetres of attached first and second sheet on both sides of its location.

Further, it is advantageous in that it has the effect that mounting of two adjacent wire ends is easier than if two adjacent wires located in the flexible band was located closer to each other than 0.5 - 3 centimetres due to degree of flexibility of first wire ends located adjacent to each other in the flexible band.

According to an embodiment of the invention, the flexible band is located at least 2 centimetres, preferably at least 5 centimetres from the first wire ends. This is advantageous in that it has the effect that mounting of two adjacent wire ends is easier than if the flexible band was located less than 2 centimetres from the first wire ends due to degree of flexibility from first wire end to its fixed location in the flexible band.

According to an embodiment of the invention, the wire harness is established based on an electric wire layout of the electric panel, the electric wire layout being designed by a first work person and stored in a data storage communicating with a computer device,
wherein the wire harness is equipped with a physical tag which upon scanned with a scanner is linking the physical wire harness to the digital representation of the electric wire layout stored in the data storage,
wherein upon scanning of the tag, the digital representation of the electric wire harness is displayed to a second work person mounting wire harness in the electric panel, and
wherein the displaying of the digital representation of the electric wire harness is made so as to display the routing of the wire to be mounted in the electric panel.

The wire harness may be established manually, but preferably automatic by a wire harness manufacturing machinery. The tag is preferably a sticker with a barcode, QR code or similar passive tag. The scanner may be any suitable scanner device such as a dedicated scanner, smartphone, etc. The tag is preferably scanned by the second work person. Displaying the routing of the wire to be mounted is advantage in that the second work person can simply follow the routing on the display and do not need any particular introduction before being able to mount a wire harness. Hence, the second work person can be less educated than the first work person.

According to an embodiment of the invention, mounting a wire harness includes the following steps:
a) place a wire harness and an electric panel in the assembly station,
b) scan the tag of the wire harness to enable the computer device to display on the screen wire layout or wire routing of a first wire of the wire harness in the electric panel,
c) mount the first wire end and the second wire end of the first wire to equipment in the electric panel according to the wire layout or wire routing,
d) upon mounting of the first wire, provide information to the computer device that the first wire is mounted, for the computer device to display wire layout or wire routing of a second wire of the wire harness on the screen,
e) repeat step d) until all wires of the wire harness are mounted in the electric panel, and
f) provide information the computer device that the wire harness is fully mounted.

Providing information to the computer device is preferably made by pushing a bottom, scanning or by voice recognition. When the wire harness is fully mounted i.e. when the last wire is mounted, the computer automatically or upon scanning a wire harness tag continues to the subsequent wire harness if any.

According to an embodiment of the invention, the method further comprising the steps of gripping said connector with an arm and gripping device of an assembly station of the electrical panel assembly, and moving said connector by use of the arm in relation to said electrical panel equipment of the electrical panel to establish a visual aligned relation for a work person between said connector and at least one of said panel equipment.

According to an embodiment of the invention, the second ends are mounted in the matching terminals of the panel equipment.

A fourth aspect, relates to an electric panel mounting system comprising a plurality of wire harnesses for establishing electrical connection between at least two panel equipment's, the system comprising: a hanger comprising a plurality fingers for holding one or more wire harnesses,
- a computer device facilitating communicating with a data storage and a scanner,
   the data storage facilitates storing a digital representation of a plurality of wire harness layouts, the scanner facilitating scanning a tag attached to the wire harness enabling the computer device to identify the layout of the wire harness in the data storage,
- a screen facilitating displaying at least part of the identified wire harness layout and thereby guiding a work person to mount and route individual wires of the wire harness in the electric panel,
wherein the computer device facilitates displaying the routing of a subsequent wire of the wire harness in the electric panel automatically or upon receiving input form the work person.

### The figures

The invention will be explained in further detail below with reference to the figures of which
- Fig. 1: shows an example of an electrical panel (fig. 1a) and an example of the electrical panel with a schematically illustrated electric wire harness (fig. 1b),
- Fig. 2A: shows an example of an electric wire harness,
- Fig. 2B: shows an example of an electric wire harness with one type of dummy connector according to the invention,
- Fig. 2C: shows an example of an electric wire harness with another type of dummy connector according to the invention,
- Fig. 3: shows an example of an electrical panel assembly for assembling an electrical panel according to the invention,
- Fig. 4: shows the electrical panel assembly from Fig. 3 with schematically illustrated examples of a visual aligned relation for a work person of the dummy connector and electrical panel,
- Fig. 5: shows an enlargement of the gripping device in the embodiment of the electrical panel assembly, and
- Fig. 6: shows data communication elements used at the assembly station.

### Detailed description

The invention will be explained in further detail with reference to the drawings and with reference to various non-limiting examples and embodiments as it will be elucidated in the following.

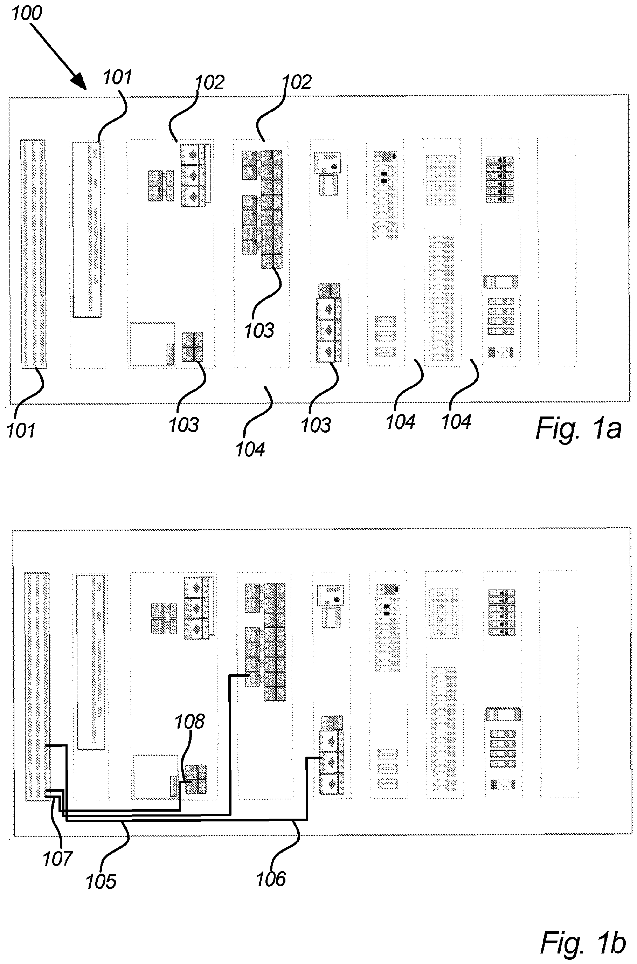

Fig. 1a shows an example of an electrical panel base plate 100 according to an embodiment of the invention. An electrical panel is typically built up by a base plate 100 on which rows of electrical components 102 are mounted typically removable mounted on DIN rails. When the base plate 100 has been equipped with the electric panel equipment it is typically wired up as will be described below, before the base plate 100 is mounted inside the actual panel (also sometimes referred to as cabinet). The panel is an enclosure designed to protect the panel equipment inside from the environment in which the panel is mounted. This environment may vary a lot, hence as an example the environment is far more aggressive in an offshore wind turbine than in an onshore wind turbine.

The electrical panel equipment includes electrical components 103 such as top or bottom terminals 101 to which external wires and cables (not illustrated) are connected and thereby establishing electrical communication with the electrical components of the cabinet. To the group of electrical components 103 also belongs contactors, timers, PLCs (PLC; Programmable Logic Controller), I/O modules, counters and other wire connected parts.

Further, the electrical panel equipment also includes DIN rails to which most of the electrical components are connected, wire ducts facilitating guiding and fixing wires between electrical components, etc.

Fig. 1b shows an example of the electrical panel base plate 100 with a schematically illustrated electric wire harness 105 according to an embodiment of the invention. The wire harness 105 always comprise a plurality of electrical wires 106 having first ends 107 and second ends 108. The first ends of the wire harness 107 are typically mounted in the terminals 101 and the second ends of the wire harness 108 are mounted in the electrical components 103. The mounting of wire ends 107, 108 can be made by screws, clips or the like.

As can be seen on fig. 1b the dimensions of the wires 106 varies. Obviously, the length is different between the terminal 101 and a component on a first row 102 compared to a component on a second row 102. What is not easy to see in fig. 1b is that the dimensions i.e. diameter, colour, type (e.g. shielded or not shielded), marking (e.g. numbering), etc. may also vary. This is due to the purpose of the electrical components 103, hence wires for control signals are often thinner than and routed separately from wires for carrying current to an electrical consumer / load.

The varying purposes and thereby demands to the wires of an electrical panel leads to within the panel a lot of "customising" of wires leading to a panel specific wire set 211 including one or more wire harnesses 105, wire bundles 212 and single wires 213. However, if e.g. a hundred identical panels are to be assembled, then the customised wire set 211 of one panel can be copied with the associated advantages.

The illustrated wires are all connecting the terminal 101 with components 103 however, wires may also be between two components 103. A plurality of such internal wires may be referred to as an internal wire harness which can be produced in the same way as the terminal 101 to components 103 wire harnesses. Hence a complete wire set 211 for a panel may comprise a plurality of sub wire harnesses 105 as the one illustrated on fig. 1b, wire bundles 212 or single wires 213.

The routing or layout of the wires 106 are also illustrated. The routing should be understood as the path the designer of the electric panel 100 has determined the wire 106 to follow from where it is mounted in its first end 107 to where it is mounted in its second end 108. The routing of each wire 106 in an electric panel 100 can be found in a digital representation of the electric system of the electric panel 100. Such digital representation or layout is typically stored in a data storage 400 accessible from a computer device 401. The computer device 401 may also be referred to as data processing device and examples hereof are laptop, server or other suitable computer devices 401.

It should be mentioned that the locations of the first wire end 107 in the connector 201 match the final locations of said first wire ends 107 in the electrical components / panel equipment 103 of the electrical panel 100. So that when loosening a wire from a first location 210 in the connector 201, the final location of the wire e.g. in a terminal block 101 is also the first i.e. a match is established between the location of the wire in the connector 201 an in the terminal block 101.

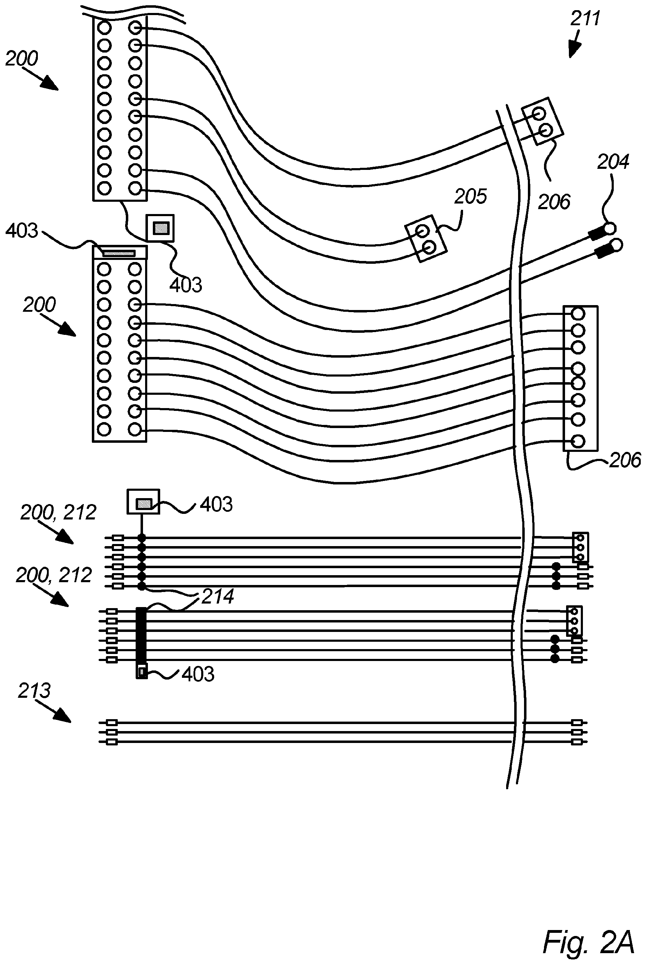

Fig. 2A shows an example of a wire set 211 comprising a plurality of wire harnesses 200 (also referred to as wire bundles) and single wires 213. A wire set 211 preferably comprise all electric wires needed for wirering up an electrical panel 100. Depending on location and purpose of the components 103 in the panel 100 wires can be grouped in harnesses and / or bundles.

It is at all time preferred to have wire ends terminated in connectors (either connectors for directly mounting or dummy connectors), however for different reasons not all wires of a panel can be included in a wire harness and terminated in a connector. The reasons are linked to the capacity of the machine producing the wire harnesses.

Typically, the machine is able to handle wires within a specific range of cross sectional area. A non-limiting example of such range could be from 0.75 to 6 square millimetres. Another limitation of the machine is the length of individual wires it can handle. Accordingly, if a wire is longer than e.g. 100 millimetres the machine may not be able to handle it and such wire may be part of a bundle of wires handled manually. Also for some reason, the engineers designing the panel may determine that one or more wires should be excluded from the wire harness.

A wire harness 200 is in this document referred to as a plurality of wires the first ends of which are connected (permanent or temporally) in a connector 201 (the connector may be a dummy connector). A wire bundle 212 is in this document referred to as a plurality of wires which are temporally connected e.g. by tape 214 i.e. always a dummy connector. A wire set 211 may comprise single wires and / or wire bundles / harnesses. Hence, when the connector 201 is implemented e.g. by tape 214, the connector is always a dummy connector and therefore a wire harness may by referred to as wire bundle and vice versa. Hence, when reference in this document is made to a wire harness, the term wire bundle could have been used equally good when the connector 201 of the wire harness is a dummy connector. Therefore, when refence in this document is made to a wire harness it includes a refence to a bundle of wires each of which are located in a dummy connector e.g. made of tape 214.

Due to location or purpose of the component 103 or the dimension of a few wires of a wire set 211 some wires may not be grouped in harnesses / bundles 200 / 212. However, it should be mentioned that it is preferred to have as few single wires 213 as possible in a wire set 211.

The number of harnesses, bundles or single wires (elements) of a wire set 211 is determined either by the person designing the electrical panel or autogenerated by a computer program based on drawings made by the person designing the electrical panel. No matter if it is manually or automatic generated, information of the individual wire harnesses/ wire bundles 200 / 212 and single wires 213 are provided to the machine making the wire sets 211. Information may be in the form of diagrams of panel layout. Such diagrams have to be converted to "wires" and this conversion is in most cases made by a piece of interface software linking information of the diagram to length, size, colour, length, grouping, etc. i.e. the dimensions of the individual wire based on which the machine makes the wire sets.

All the above designing, routing, layout, etc of wires and the electric panel 100 may be facilitated by a computer device 401 communicating with a data storage 400 and a screen 310. In this way a first (educated) work person can design the electric panel and a second (non-educated) work person can mount the electric wires. Typically, the computer device used by the first work person is different from the one used by the second work person. The second work person also referred to simply as work person may then be guided by the screen 310 on which the wires harness 200 wire by wire can be displayed.

Preferably, the wire harnesses are all equipped with a scannable tag 403 enabling linking the physical wire harness to a digital representation hereof located e.g. at the data storage 400. The tag 403 is preferably a simple passive tag such as a QR code or a barcode, RFID tag or NFC tag. The tag 403 may comprise information of the digital address or path on which the digital representation is located or facilitating starting a mounting guide of the specific wire harness.

As the elements of the wire set 211 are made they are temporally stored in one or more hangers 404. The hangers may also facilitate transporting the wire sets 211 from the machine to the assembly station where the electrical panel is assembled. The hangers 404 preferably have wheels for easy transportation and so-called fingers for holding the wires of the wire harnesses

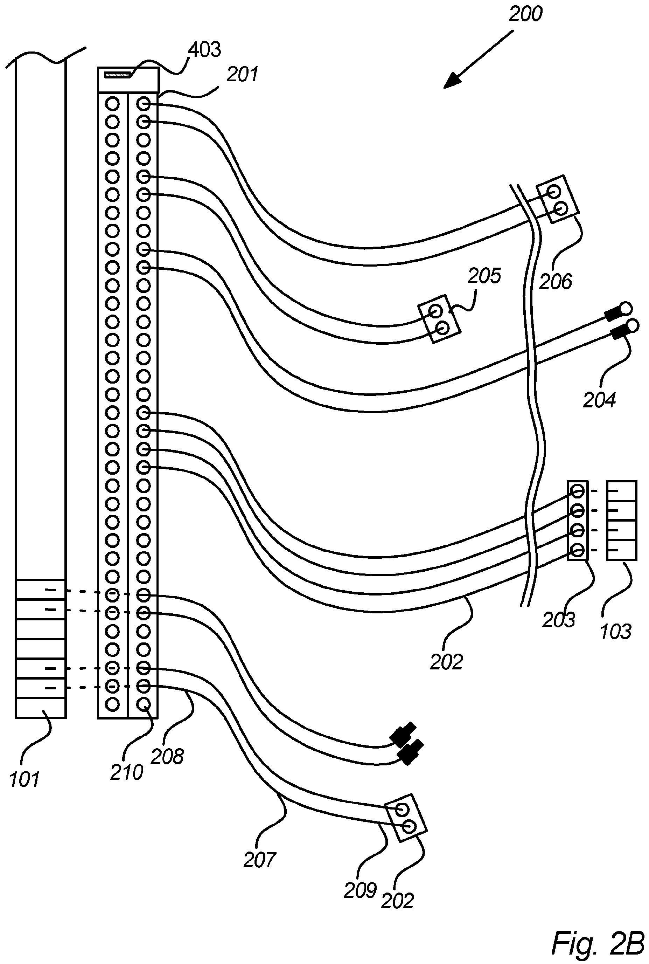

Fig. 2B shows an example of an electric wire harness 200, 105 with a connector 201 mounted at the first wire ends 208, 107 according to the invention. The illustrated connector 201 can as illustrated be partly full, or it can be completely filled up with first wire ends 208. This connector is also equipped with a tag 403 as described above.

According to a preferred embodiment, the connector is a dummy connector. A dummy connector should be understood as a temporary connector the purpose of which is to maintain the wire ends in a predetermined order or sequence. The implementation of the dummy connector is not important it may look like a conventional connector or simply be implemented by tape 214. Temporary mount of the wire ends in a dummy connector, has several effects including that during transportation of the wire harness 200, there will be no displacement or interchanging between the first wire ends 208. This has the advantage that when arriving at the panel assembly the first wire ends 208 of the wire harness 200 are in the same position as when mounted i.e. at the manufacturing of the wire harness 200.

At the manufacturing of the wire harness the first wire ends 208 is mounted in the dummy connector 201 in the order the first wire end 208 must be mounted in the terminal 101. This is possible in that the machinery manufacturing the wire harness 200 is producing based on information from the diagrams of the layout of the wiring of the panel.

At the assemble station, the work person mounting the wire harness 200 in the panel having a dummy connector then do not have to have any particular skills in electric panels mounting this person simply move wire from the first terminal / location in the dummy connector to the first terminal in the top terminal row 101. The second wire in the dummy connector to the second terminal in the top terminal row 101 and so forth.

When all wires of the dummy connector are mounted in the terminal 101, the next wire harness / wire bundle 200 / 212 or single wires 213 of the wire set 211 if required for the specific panel is ready to be mounted in the panel.

The second ends of the wire harness 209, 108 are either terminated in one or more further dummy connectors / further permanent connectors 202-206, various types of cable clamps or what is required. The termination of the second ends 209 is determined by the electrical component 103 to which they need to be mounted. Hence, if four wires of the harness 200 is to be mounted at the same component 103 in a specific order, then the relevant second ends are preferably mounted in a further dummy connector 203 in that order. This also leads to an easy mounting of the second wire ends one to one at the terminal of the component 103 i.e. removing the first wire from the further dummy connector terminal and mount it in the first terminal of the component 103. Removing the second wire from the further dummy connector terminal and mount it in the second terminal of the component 103 and so on.

If the component 103 is equipped with a connector facilitating mounting the second wire ends 209 directly hereto, it is advantages to mount a further permanent connector at the second ends of the relevant wires of the wire harness 200. Preferably the further permanent connector mounted on the component 103 is a female connector and the further permanent connector of the wire harness 200 is a male connector.

If the terminal of the component 103 to which a second end of a wire harness 209 should be mounted requires special termination of the second wire end 209 this is mounted at the machinery manufacturing of the wire harness 200. Further, if only one wire is required at a component 103 the second end 209 can simply be striped and thereby ready to easy mounting.

The machinery manufacturing the wire harness 200 preferably also automatically place the wire harness 200 in a temporary storage or at least enable a work person to temporary store the wire harness 200. If a complete wire set 211 for a panel includes e.g. four independent wire harnesses 200 these are preferably temporally stored in a way so the work person mounting them intuitive can take the first, second, third and then fourth wire harness 200 when needed. A temporary storage of wire harnesses 200 facilitate this sequential storage e.g. by means of numbering or colouring the holding means. Further, a temporary storage is preferably movable i.e. a work person can move the temporary storage from one place to another easily. A temporarily storage complying with these demands could be a coat tree like structure or hanger with hangers or fingers for holding the connectors 201 of the wire harness 200. Such coat tree like structure is advantages in that long wires can be stored without the second ends are in contact with the floor and a plurality of wire harnesses 200 of a complete wire harness can be stored easily at one coat tree. Alternative, other structure such as tables or baskets could be use. All of the storages are preferably mounted with wheels for easy moving.

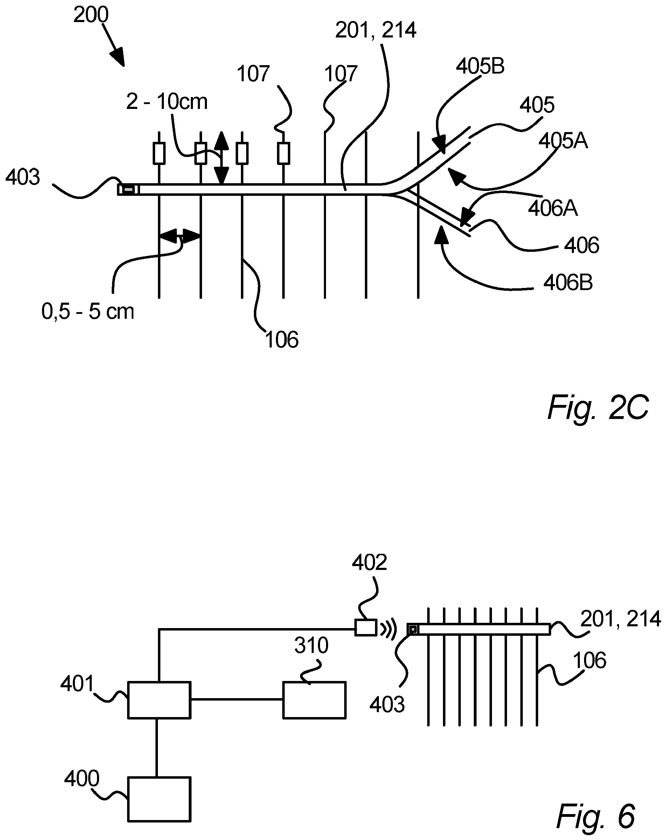

Fig. 2C illustrates a wire harness 200 the connector 201 of which is a tape 214 or other types of flexible band. The flexible band illustrated on Fig. 2C comprises a first sheet 405 and a second sheet 406. The first sheet 405 having a first side 405A and a second side 405B and the second sheet having a first side 406A and a second side 406B. the first sides of the sheets 405, 406 are adhesive hence when put together the stick together and forms a stronger flexible band together than individual.

When wires 106 are located between the sheets 405, 406 a dummy connector is created by means of the flexible band / tape 214. The order in which the wires are located in the dummy connector is the order determined by the layout of the electric panel and the order in which the wires are to be mounted in the electric panel.

To facilitate flexibility enough for easy mounting, the distance between center of wires 106 located in the dummy tape connector 201 / 214 is preferably between 0.5 and 5 centimetres with 2 centimetres as preferred. In the same way, the distance from the first ends 107 of wires 106 to the dummy tape connector 201/214 is between 2 centimetres and 10 centimetres with between 4 and 6 centimetres as preferred for ease mounting and ripping off wires from the dummy tape connector 201/214.

The adhesive on the one side of the first and or second sheets 405, 406 may be a conventional glue hence industrial tape can be used as dummy tape connector.

In an embodiment, before mounting a wire harness 200 it is stored in a second temporary storage which is referred to as a hanger 404. Preferably, the hanger 404 has fingers 407 between which one or more wires 106 of the wire harness 200 can be located thereby the tape dummy connector 201/214 rests on the fingers and thereby holding the wire harness 200.

In an embodiment, before mounting a wire harness 200 it is stored in a second temporary storage which is referred to as a connector fixture 304. The connector fixture 304 has recesses for temporary mounting of the connectors 201 during the mounting of the wire harness 200. This is advantageous in that the work person then is in control of both first and second ends 208, 209 of the wire harness 200 during mounting.

It should be mentioned, that the coat tree and or connector fixture 304 is preferably equipped with a tracking device to tracing of the wire harnessed are possible such as a scannable tag 403. Also, the individual connectors may be equipped with tracking device for facilitating tracking within the panel assembly process.

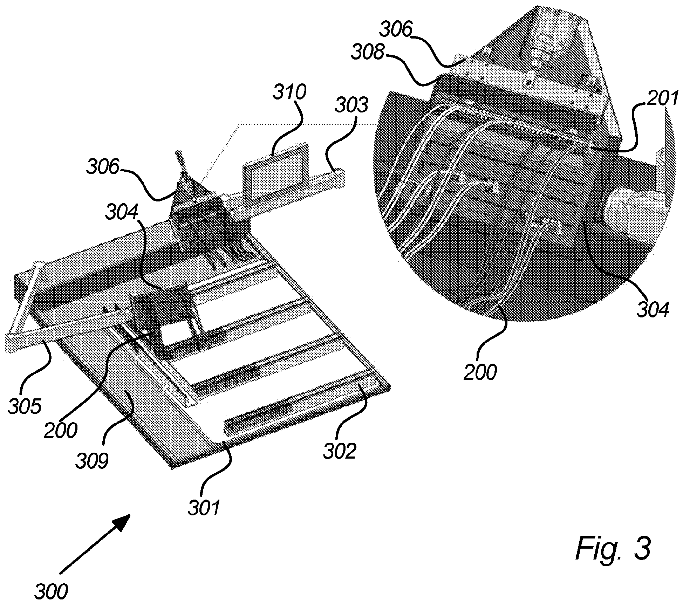

Fig. 3 shows an example of an electrical panel assembly 300 for assembling an electrical panel according to an embodiment of the invention where the connector is not a dummy tape connector 201 /214. The panel assembly 300 preferably comprises an assembly base 309 on or to which an electrical panel base plate 301 is positioned. If not mounted before the base plate 301 is positioned at the assembly base 309, the wire ducts 302, 104, DIN rails (not illustrated) and components 103 (not illustrated) are mounted on the base plate 301.

The panel assembly 300 further comprise one or more assembly stations 303, 305 in the form of arms with auxiliary tools helping the work person to easy mounting the wire harnesses 200. An example of an auxiliary tool is an arm with a gripping device 306 at the end. The gripping device 306 facilitates temporary holding a connector fixture 304, further it may comprise a handle which when used releases the first wire ends 208 of the connector 201. Preferably the gripping device 306 comprise a handle which when activated e.g. by pulling it one direction loosens the wire in the first location of the dummy connector. When the handle is pushed (manually or mechanically) in the opposite direction it preferably travels a distance to the right. The travel can be obtained by any kind of recess or helical structure of a rod to which the handle is movably fasten to. The traveling distance is matched with the distance between the locations of the temporary connector so that the next time the handle is pulled, the wire of the second location of the temporary connector is loosened.

Another example of an auxiliary tool is a connector fixture 304 permanently mounted at an arm 305. Yet another example is a screen 310 by means of which the work person can be guided through the mounting of the wire harness 200.

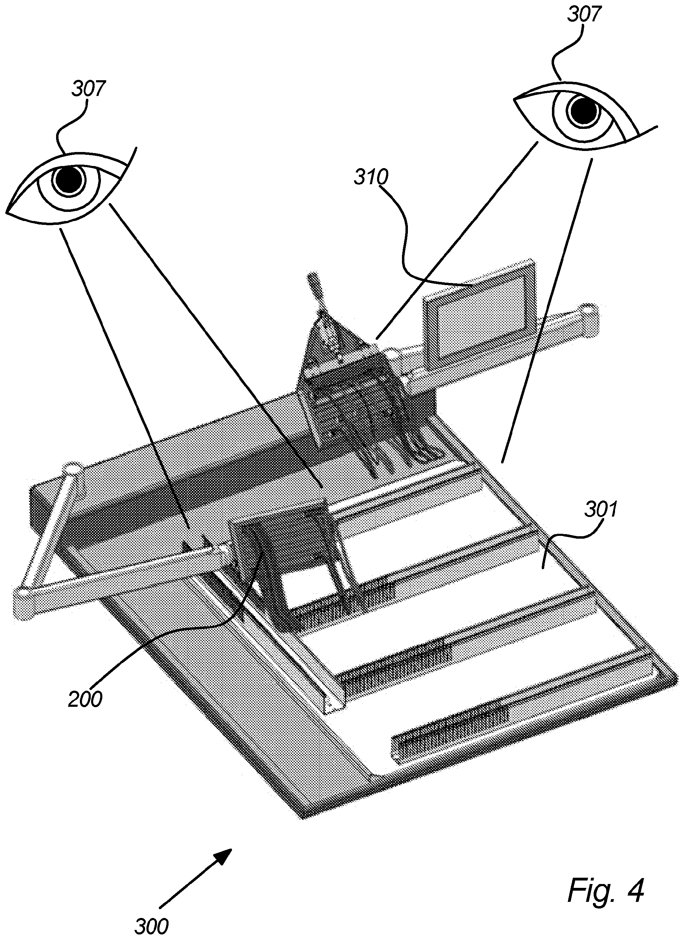

Fig. 4 shows the electrical panel assembly 300 from Fig. 3 with schematically illustrated examples of a visual aligned relation for a work person of the dummy connector 201 and electrical panel base plate 301. The temporary storage of the wire harness 200 at the assembly stations 303, 305 in the form of a movable (sometimes referred to as a robotic) arm helps the work person to always be able to have the wire ends 208, 209 close to the component 103 where it is to be mounted. Thereby is obtained a visual alignment between the wire temporary located in a dummy connector 201 of the connector fixture 304 and the terminal at the base plate 301 where it is to be mounted. For the second wire ends 209 whether they are terminated in a connector or cable clamp also here a visual alignment is obtained. If in addition a guiding can be followed at the screed 310 a very easy, fast and fault reducing mounting process is established.

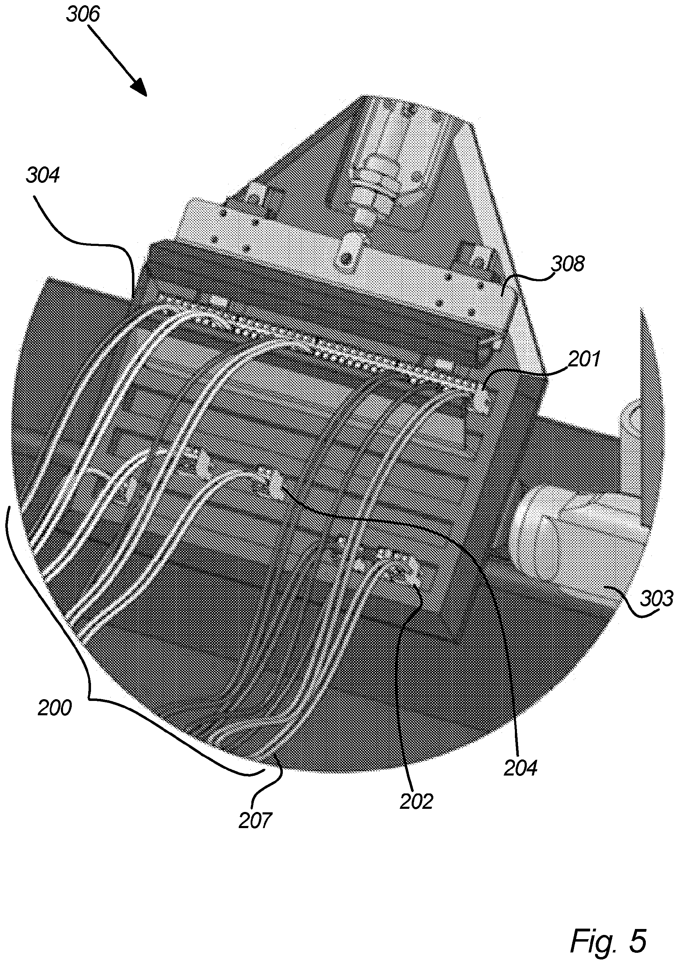

Fig. 5 shows an enlargement of the gripping device 306 in the embodiment of the electrical panel assembly. The griping device 306 preferably comprise an engaging part 308 for holding the connector fixture 304. The engaging part 308 may facilitate easy replacement of the connector fixture 304 or release of first wire ends 208 of the connector 201. It is seen that not all terminals of the connector 201 is used. This it because the first wire ends of this particular wire harness 200 is not to be mounted in a continuous sequence of terminals. In other embodiments, all terminals of the connector 201 would be used in both the upper and lower row. This is completely up to the wire layout of the individual panel, but it does not affect the mounting in that the first wire ends 207 should still be mounted one - to - one or mounted as displayed at the screen 310.

In relation to Fig. 3 - Fig. 5 are all connectors 201 mentioned dummy connectors holding first wire ends 208 of the wire harness 200 which is advantageous as explained above.

When the wire harness 200 is equipped with a dummy tape connector 214 as illustrated on Fig. 2C, the panel assemble 300 illustrated on Fig. 3 - Fig. 5 is modified. Instead of the connector fixture 304, further assembly station 305 and gripping device 306 one or more hangers 404 as illustrated on Fig. 2C can be used to hold wire harnesses 200 of a wire set 211 in the mounting cell.

The work person takes one wire harness 200 at the time, scanning the tag and on the screen 310 (which do not have to be mounted on a robotic arm 303 as illustrated on Fig. 3 and 4) the work person will be guided wire by wire through the mounting of wires of the wire harness. While mounting a wire 106 separated (teared apart) from the tape dummy connector 214 of figure Fig. 2C of the wire harness 200, the remaining part of the wire harness 200 may be positioned on the assembly base 309, on the hanger 404 or where appropriate.

Fig. 6 illustrates an example of a system facilitating the guiding of wire mounting including routing of the wire 106 in the electric panel. The system comprises a computer device 401 communicating with a data storage 400, a screen 310 and a scanner 402. The individual parts of the system is conventional industrial parts, but connected together and controlled as described the system ensures fast, uniform and error proved mounting of wires in an electrical panel. This is because the control software is receiving a unique wire harness identification from the scanner 402 scanning the tag 403. This information is in data storage 400 associated with the digital representation of where wires ends 107, 108 of that particular wire harness 106 are to be mounted and in addition preferably also the routing of the wire 106 through the electric panel.

The routing is important in that random routing may cause EMC errors, coupling of signals between wires due to magnetic fields, mix of data and current wires, to high temperature in wire ducts, etc. All these and other considerations are carefully made by the designer of the electric system and therefore each wire have to follow a particular route through the electric panel. The uneducated work person mounting the wires do not know about all this and therefore can easily place a wire wrong in the cable ducts in the electric panels. This problem is completely eliminated by the described system where routing of each wire is displayed to the work person.

It should be mentioned that in case all wire ends are fixed in connectors such as permanent connectors and the equipment of the electrical panel is prepared to receive such permanent connectors, an electrically controlled robotic arm may facilitate assembling at least the majority of wires in an electrical panel. The routing of wires in wire ducts between panel equipment can also be made by an electrically controlled robotic arm. Hence, the present invention enables an almost complete automated assembly of an electric panel.

### List of reference numbers

- 100.: Electrical panel base plate including electrical panel equipment
- 101.: Terminal blocks
- 102.: Row of electric components
- 103.: Electric components
- 104.: Wire duct
- 105.: Electric wire harness
- 106.: Wire in the electric wire harness
- 107.: First end of a wire in the electric wire harness
- 108.: Second end of a wire in the electric wire harness
- 200.: Electric wire harness according to the invention (105)
- 201.: Connector for the first ends of the wires
- 202-206.: Further connectors / terminations for the second ends of the wires
- 207.: Wire in the electric wire harness according to the invention (106)
- 208.: First end of a wire in the electric wire harness (107)
- 209.: Second end of a wire in the electric wire harness (108)
- 210.: Dummy collector terminal for a first end of a wire
- 211.: Wire set
- 212.: Wire bundle
- 213.: Single wires
- 214.: Tape / flexible band / dummy tape connector
- 300.: Electrical panel assembly according to the invention
- 301.: Electrical panel base plate (100)
- 302.: Wire duct (104)
- 303.: An assembly station with an arm
- 304.: Connector fixture for holding a connector of a wire harness
- 305.: Further assembly station with an arm
- 306.: Gripping device in one end of the arm for holding a connector fixture
- 307.: Eyeing for the work person of visual alignment
- 308.: Engaging part in the gripping device for holding a connector fixture
- 309.: An assembly base
- 310.: A screen
- 400.: Data storage
- 401: Computer device
- 402.: Scanner
- 403.: Tag
- 404.: hanger
- 405: first sheet
- 406: second sheet
- 407: fingers of the hanger

## Claims

1. Electric wire harness (105) established based on an electric wire layout of an electrical panel (100) prepared for connecting electrical panel equipment (103) of said electrical panel (100), the wire harness (105) comprising:
a plurality of electric wires (106) of different dimensions having first and second wire ends (107, 108), and
a connector (201) with locations (210) for fastening and storage of a plurality of said first wire ends (107),
where the locations of said first wire ends (107) in said connector (201) match the final locations of said first wire ends (107) in the electrical panel (100),
wherein the electric wire harness (105) is **characterized in that** the connector (201) is a dummy connector with terminals (210) for temporary connection and storage of a plurality of said first wire ends (107), and
**in that** the sequence of the wires in the connector (201) is determined by the electric wire layout of the electric panel.

2. Electric wire harness (105) according to claim 1, wherein the electric wire harness is equipped with a tag linking the sequence of wires in the connector to a digital electric layout of the electrical panel.

3. Electric wire harness (105) according to any of the preceding claims, wherein said wire harness (105) comprises one or more further dummy connectors (205, 206) with terminals for temporary connection and storage of a plurality of said second wire ends (108).

4. Electric wire harness (105) according to any of the preceding claims, wherein said connectors of the wire harness (105) prior to mounting in the panel (100) are configured to be temporary attached to and stored at a connector fixture.

5. An electrical panel assembly (300) for assembling an electrical panel (100), said assembly comprising:
an assembly table or fixture for holding the electrical panel (100),
at least one electrical panel mounted in said assembly table or fixture where said panel (100) includes electrical panel equipment (103) such as terminal blocks, rows of electric components (103) and wire ducts (302),
at least one electric wire harness (105) according to any of the claims 1 to 4 for mounting in and wiring said electrical panel (100) by at least one work person, and
wherein said assembly further comprises a screen (310) displaying or guiding the work person to where the wire ends of the wire harness should be mounted in the electrical panel.

6. An electrical panel assembly (300) according to claim 5, wherein the assembly further comprises a computer device facilitating communication with a data storage and a scanner, wherein the data storage is storing a plurality of electric wire layouts of the electric panel, wherein the electric wire layout in the computer device is linked to unique tag information, and
wherein the displaying or guiding on the screen (310) is established by the computer device facilitating matching received tag information from the scanner upon scanning a tag physically linked to the wire harness, with an electric wire layout from the data storage.

7. An electric panel assembly according to any of the claims 5 or 6, wherein the displaying on the screen facilitates guiding a work person wire by wire through the mounting of the wire harness in the electric panel, wherein the display is configured for displaying routing of the subsequent wire after the work person has provided input to the computer device or a determined time has passed.

8. An electrical panel assembly (300) according to any of the claims 5 to 7, wherein the at least one assembly station comprises an arm (303) for holding at least one of the connectors of said electric wire harness (105),
where said at least one connector is movable by use of the arm in relation to said electrical panel equipment (103) of the electrical panel to establish a visual aligned relation for said work person between said at least one connector and at least one of said equipment.

9. An electrical panel assembly (300) according to any of the claims 5 to 8, wherein said arm is a robotic arm with a gripping device (306) at one end for holding said at least one connector and arm joints allowing rotational and/or translational displacement of the one end of said arm holding said at least one connector.

10. An electrical panel assembly (300) according to any of the claims 5 to 9, wherein said assembly further comprises a robot configured for picking up a connector from the connector fixture and mounting the connector at a determined panel equipment.

11. Method for assembling an electrical panel (100) including electrical panel equipment (103), said method comprising the steps of:
locating first wire ends (107) of an electric wire harness (105) in a connector (201) in locations (210) matching the final locations of said first wire ends (107) in the electrical panel (100),
wherein the electric wire harness (105) is prepared for connecting electrical panel equipment (103) of an electrical panel (100), the wire harness (105) comprising:
a plurality of electric wires (106) of different dimensions having first and second wire ends (107, 108), and
a connector (201) with locations (210) for fastening and storage of a plurality of said first wire ends (107),
where the locations of said first wire ends (107) in said connector (201) match the final locations of said first wire ends (107) in the electrical panel (100),
mounting the electrical panel (100) in an electrical panel assembly (300) according to any of the claims 5 to 10,
removing a first end of a first wire (107) from a first location (210) of the connector (201),
mounting the first end of the first wire (107) in the matching terminal (101) of the electrical panel (100),
mounting a second end of the first wire (108) in the electrical panel (100), and
mounting the further wire ends of the electric wire harness (105) in the electrical panel.

12. A method according to claim 11, wherein the electric wire harness (105) is created by locating the first wire ends (107) between a first sheet and a second sheet of a flexible band, wherein the first sheet and the second sheet are attached to each other between the locations (210) of the first wire ends (107) along the length of the flexible band.

13. A method according to any of the preceding claims 11 or 12, wherein the wire harness is established based on an electric wire layout of the electric panel, the electric wire layout being designed by a first work person and stored in a data storage communicating with a computer device,
wherein the wire harness is equipped with a physical tag which upon scanned with a scanner is linking the physical wire harness to the digital representation of the electric wire layout stored in the data storage,
wherein upon scanning of the tag, the digital representation of the electric wire harness is displayed to a second work person mounting wire harness in the electric panel, and
wherein the displaying of the digital representation of the electric wire harness is made so as to display the routing of the wire to be mounted in the electric panel.

14. A method according to any of the preceding claims 11 to 13, wherein mounting a wire harness includes the following steps:
a) place a wire harness and an electric panel in the assembly station,
b) scan the tag of the wire harness to enable the computer device to display on the screen wire layout or wire routing of a first wire of the wire harness in the electric panel,
c) mount the first wire end and the second wire end of the first wire to equipment in the electric panel according to the wire layout or wire routing,
d) upon mounting of the first wire, provide information to the computer device that the first wire is mounted, for the computer device to display wire layout or wire routing of a second wire of the wire harness on the screen,
e) repeat step d) until all wires of the wire harness are mounted in the electric panel, and
f) provide information the computer device that the wire harness is fully mounted.

15. A method according to any of the preceding claims 11 to 14, wherein the method further comprising the steps of gripping said connector (201) with an arm and gripping device of an assembly station of the electrical panel assembly, and
moving said connector (201) by use of the arm in relation to said electrical panel equipment (103) of the electrical panel to establish a visual aligned relation for a work person between said connector (201) and at least one of said panel equipment (103).

## Patentansprüche

1. Elektrokabelbaum (105), der basierend auf einem Elektroleitungslayout einer Elektroschalttafel (100) eingerichtet ist, die zum Verbinden von Elektroschalttafelausrüstungen (103) der Elektroschalttafel (100) vorbereitet ist, wobei der Kabelbaum (105) umfasst:
eine Vielzahl von Elektroleitungen (106) unterschiedlicher Abmessungen, die ein erstes und ein zweites Leitungsende (107, 108) aufweisen, und
einen Verbinder (201) mit Positionen (210) zum Befestigen und zur Ablage einer Vielzahl der ersten Leitungsenden (107),
wobei die Positionen der ersten Leitungsenden (107) in dem Verbinder (201) den endgültigen Positionen der ersten Leitungsenden (107) an der Elektroschalttafel (100) entsprechen,
wobei der Elektrokabelbaum (105) **dadurch gekennzeichnet ist, dass** der Verbinder (201) ein Dummy-Verbinder mit Anschlussklemmen (210) zur zeitweiligen Verbindung und Ablage einer Vielzahl der ersten Leitungsenden (107) ist, und
dadurch, dass die Abfolge der Leitungen in dem Verbinder (201) durch das Elektroleitungslayout der Elektroschalttafel bestimmt wird.

2. Elektrokabelbaum (105) nach Anspruch 1, wobei der Elektrokabelbaum mit einem Kennzeichen ausgestattet ist, das die Abfolge von Leitungen in dem Verbinder mit einem digitalen Elektrolayout der Elektroschalttafel verknüpft.

3. Elektrokabelbaum (105) nach einem der vorstehenden Ansprüche, wobei der Kabelbaum (105) einen oder mehrere weitere Dummy-Verbinder (205, 206) mit Anschlussklemmen zur zeitweiligen Verbindung und Ablage einer Vielzahl der zweiten Leitungsenden (108) umfasst.

4. Elektrokabelbaum (105) nach einem der vorstehenden Ansprüche, wobei die Verbinder des Kabelbaums (105) vor der Montage in der Schalttafel (100) konfiguriert sind, um zeitweilig an einer Verbinderhalterung angebracht und abgelegt zu werden.

5. Elektroschalttafelanordnung (300) zum Montieren einer Elektroschalttafel (100), wobei die Anordnung umfasst:
einen Montagetisch oder eine Halterung zum Halten der Elektroschalttafel (100),
mindestens eine Elektroschalttafel, die in dem Montagetisch oder der Halterung montiert ist, wobei die Schalttafel (100) eine Elektroschalttafelausrüstung (103) wie Anschlussklemmenblöcke, Reihen von Elektrokomponenten (103) und Leitungskanäle (302) einschließt,
mindestens einen Elektrokabelbaum (105) nach einem der Ansprüche 1 bis 4 zur Montage und Verdrahtung der Elektroschalttafel (100) durch mindestens einen Arbeiter,
und
wobei die Anordnung ferner einen Bildschirm (310) umfasst, der dem Arbeiter anzeigt oder ihn anleitet, wohin die Leitungsenden des Elektrokabelbaums an der Elektroschalttafel montiert werden sollen.

6. Elektroschalttafelanordnung (300) nach Anspruch 5, wobei die Anordnung ferner eine Computervorrichtung umfasst, die die Kommunikation mit einem Datenspeicher und einem Scanner ermöglicht, wobei der Datenspeicher eine Vielzahl von Elektroleitungslayouts speichert, wobei das Elektrolayout in der Computervorrichtung mit eindeutigen Kennzeichnungsinformationen verknüpft ist, und
wobei das Anzeigen oder Anleiten auf dem Bildschirm (310) erreicht wird, indem die Computervorrichtung das Abgleichen von Kennzeichnungsinformationen, die nach dem Scannen eines Kennzeichens von dem Scanner empfangen wurden, das physisch mit dem Elektrokabelbaum verknüpft ist, mit einem Elektroleitungslayout aus dem Datenspeicher ermöglicht.

7. Elektroschalttafelanordnung nach einem der Ansprüche 5 oder 6, wobei das Anzeigen auf dem Bildschirm das leitungsweise erfolgende Anleiten eines Arbeiters durch die Montage des Kabelbaums in der Elektroschalttafel ermöglicht, wobei die Anzeige konfiguriert ist, um die Leitungsführung der nachfolgenden Leitung anzuzeigen, nachdem der Arbeiter der Computervorrichtung eine Eingabe bereitgestellt hat oder eine vorgegebene Zeit abgelaufen ist.

8. Elektroschalttafelanordnung (300) nach einem der Ansprüche 5 bis 7, wobei die mindestens eine Montagestation einen Arm (303) zum Halten mindestens eines der Verbinder des Elektrokabelbaums (105) umfasst,
wobei der mindestens eine Verbinder durch Verwendung des Arms in Bezug auf die Elektroschalttafelausrüstung (103) der Elektroschalttafel beweglich ist, um eine visuelle Ausrichtungsbeziehung für den Arbeiter zwischen dem mindestens einen Verbinder und mindestens einer der Ausrüstungen herzustellen.

9. Elektroschalttafelanordnung (300) nach einem der Ansprüche 5 bis 8, wobei der Arm ein Roboterarm mit einer Greifvorrichtung (306) an einem Ende zum Halten des mindestens einen Verbinders und von Armgelenken ist, die eine Rotations- und/oder Translationsverschiebung des einen Endes des Arms ermöglichen, der den mindestens einen Verbinder hält.

10. Elektroschalttafelanordnung (300) nach einem der Ansprüche 5 bis 9, wobei die Anordnung ferner einen Roboter umfasst, der konfiguriert ist, um einen Verbinder von der Verbinderhalterung aufzunehmen und den Verbinder an einer bestimmten Tafelausrüstung zu montieren.

11. Verfahren zum Montieren einer Elektroschalttafel (100), die eine Elektroschalttafelausrüstung (103) einschließt, wobei das Verfahren die Schritte umfasst:
Anordnen von ersten Leitungsenden (107) eines Elektrokabelbaums (105) an einem Verbinder (201) an Positionen (210), die den endgültigen Positionen der ersten Leitungsenden (107) an der Elektroschalttafel (100) entsprechen,
wobei der Elektrokabelbaum (105) zum Verbinden einer Elektroschalttafelausrüstung (103) einer Elektroschalttafel (100) vorbereitet ist, wobei der Kabelbaum (105) umfasst:
eine Vielzahl von Elektroleitungen (106) unterschiedlicher Abmessungen, die erste und zweite Leitungsenden (107, 108) aufweisen, und
einen Verbinder (201) mit Positionen (210) zum Befestigen und zur Ablage einer Vielzahl der ersten Leitungsenden (107),
wobei die Positionen der ersten Leitungsenden (107) in dem Verbinder (201) den endgültigen Positionen der ersten Leitungsenden (107) an der Elektroschalttafel (100) entsprechen,
Montieren der Elektroschalttafel (100) in einer Elektroschalttafelanordnung (300) nach einem der Ansprüche 5 bis 10,
Entfernen eines ersten Endes einer ersten Leitung (107) von einer ersten Position (210) des Verbinders (201),
Montieren des ersten Endes der ersten Leitung (107) an der passenden Anschlussklemme (101) der Elektroschalttafel (100),
Montieren eines zweiten Endes der ersten Leitung (108) an der Elektroschalttafel (100) und Montieren der weiteren Leitungsenden des Elektrokabelbaums (105) an der Elektroschalttafel.

12. Verfahren nach Anspruch 11, wobei der Elektrokabelbaum (105) durch Anordnen der ersten Leitungsenden (107) zwischen einer ersten Lage und einer zweiten Lage eines flexiblen Bandes erstellt wird, wobei die erste Lage und die zweite Lage zwischen den Positionen (210) der ersten Leitungsenden (107) entlang der Länge des flexiblen Bandes aneinander befestigt werden.

13. Verfahren nach einem der vorstehenden Ansprüche 11 oder 12, wobei der Kabelbaum basierend auf einem Elektroleitungslayout der Elektroschalttafel hergestellt wird, wobei das Elektroleitungslayout von einem ersten Arbeiter konzipiert und in einem Datenspeicher gespeichert wird, der mit einer Computervorrichtung kommuniziert,
wobei der Kabelbaum mit einem physischen Kennzeichen ausgestattet ist, das nach dem Scannen mit einem Scanner den physischen Kabelbaum mit der digitalen Darstellung des in der Datenspeicherung gespeicherten Elektroleitungslayouts verknüpft,
wobei nach dem Scannen des Kennzeichens die digitale Darstellung des Elektrokabelbaums einem zweiten Arbeiter zum Montieren des Kabelbaums an der Elektroschalttafel angezeigt wird, und
wobei das Anzeigen der digitalen Darstellung des Elektrokabelbaums so vorgenommen wird, dass die Führung der an der Elektroschalttafel zu montierenden Leitung angezeigt wird.

14. Verfahren nach einem der vorstehenden Ansprüche 11 bis 13, wobei das Montieren eines Kabelbaums die folgenden Schritte einschließt:
a) Platzieren eines Kabelbaums und einer Elektroschalttafel in der Montagestation,
b) Scannen des Kennzeichens des Kabelbaums, um der Computervorrichtung zu ermöglichen, auf dem Bildschirm ein Leitungslayout oder eine Leitungsführung einer ersten Leitung des Kabelbaums an der Elektroschalttafel anzuzeigen,
c) Montieren des ersten Leitungsendes und des zweiten Leitungsendes der ersten Leitung an einer Ausrüstung an der Elektroschalttafel gemäß dem Leitungslayout oder der Leitungsführung,
d) nach dem Montieren der ersten Leitung, Bereitstellen von Informationen für die Computervorrichtung, dass die erste Leitung montiert ist, um ein Leitungslayout oder eine Leitungsführung einer zweiten Leitung des Kabelbaums auf dem Bildschirm anzuzeigen,
e) Wiederholen von Schritt d), bis alle Leitungen des Kabelbaums an der Elektroschalttafel montiert sind, und
f) Bereitstellen von Informationen für die Computervorrichtung, dass der Kabelbaum vollständig montiert ist.

15. Verfahren nach einem der vorstehenden Ansprüche 11 bis 14, wobei das Verfahren ferner die Schritte des Greifens des Verbinders (201) mit einer Arm- und Greifvorrichtung einer Montagestation der Elektroschalttafelanordnung, und
des Bewegens des Verbinders (201) durch Verwendung des Arms in Bezug auf die Elektroschalttafelausrüstung (103) der Elektroschalttafel, um eine visuelle Ausrichtung für einen Arbeiter zwischen dem Verbinder (201) und mindestens einer der Schaltafelausrüstung (103) herzustellen.

## Revendications

1. Faisceau de câbles électriques (105) établi sur la base d'une disposition de câbles électriques d'un panneau électrique (100) préparé pour connecter un équipement de panneau électrique (103) dudit panneau électrique (100), le faisceau de câbles (105) comprenant :
une pluralité de câbles électriques (106) de dimensions différentes ayant de premières et secondes extrémités de câble (107, 108), et
un connecteur (201) avec des emplacements (210) permettant de fixer et de stocker une pluralité desdites premières extrémités de câble (107),
où les emplacements desdites premières extrémités de câble (107) dans ledit connecteur (201) correspondent aux emplacements finaux desdites premières extrémités de câble (107) dans le panneau électrique (100),
dans lequel le faisceau de câbles électriques (105) est **caractérisé en ce que** le connecteur (201) est un connecteur factice avec des bornes (210) pour une connexion et un stockage temporaires d'une pluralité desdites premières extrémités de câble (107), **et**
**en ce que** la séquence des câbles dans le connecteur (201) est déterminée par la disposition de câbles électriques du panneau électrique.

2. Faisceau de câbles électriques (105) selon la revendication 1, dans lequel le faisceau de câbles électriques est équipé d'une étiquette reliant la séquence de câbles dans le connecteur à une disposition électrique numérique du panneau électrique.

3. Faisceau de câbles électriques (105) selon l'une quelconque des revendications précédentes, dans lequel ledit faisceau de câbles (105) comprend un ou plusieurs autres connecteurs factices (205, 206) avec des bornes pour une connexion et un stockage temporaires d'une pluralité desdites secondes extrémités de câble (108).

4. Faisceau de câbles électriques (105) selon l'une quelconque des revendications précédentes, dans lequel lesdits connecteurs du faisceau de câbles (105) avant le montage dans le panneau (100) sont configurés pour être fixés temporairement à une fixation de connecteur et stockés temporairement au niveau de celle-ci.

5. Ensemble de panneau électrique (300) permettant d'assembler un panneau électrique (100), ledit ensemble comprenant :
une table d'assemblage ou une fixation destinée à maintenir le panneau électrique (100),
au moins un panneau électrique monté dans ladite table d'assemblage ou la fixation où ledit panneau (100) comporte un équipement de panneau électrique (103) tel que des blocs de bornes, des rangées de composants électriques (103) et des conduits de câbles (302),
au moins un faisceau de câbles électriques (105) selon l'une quelconque des revendications 1 à 4 permettant à au moins un ouvrier de monter et de câbler ledit panneau électrique (100),
et
dans lequel ledit ensemble comprend en outre un écran (310) affichant ou guidant l'ouvrier vers l'emplacement où les extrémités de câble du faisceau de câbles doivent être montées dans le panneau électrique.

6. Ensemble de panneau électrique (300) selon la revendication 5, dans lequel l'ensemble comprend en outre un dispositif informatique facilitant la communication avec un stockage de données et un scanneur, dans lequel le stockage de données stocke une pluralité de dispositions de câbles électriques du panneau électrique, dans lequel la disposition de câbles électriques dans le dispositif informatique est reliée à des informations d'étiquette uniques, et
dans lequel l'affichage ou le guidage sur l'écran (310) est établi par le dispositif informatique facilitant la mise en correspondance d'informations d'étiquette provenant du scanneur lors de l'analyse d'une étiquette physiquement reliée au faisceau de câbles, avec une disposition de câbles électriques provenant du stockage de données.

7. Ensemble de panneau électrique selon l'une quelconque des revendications 5 ou 6, dans lequel l'affichage sur l'écran facilite le guidage d'un ouvrier câble par câble à travers le montage du faisceau de câbles dans le panneau électrique, dans lequel l'affichage est configuré pour afficher un tracé du câble ultérieur après que l'ouvrier a fourni une entrée au dispositif informatique ou qu'une durée déterminée est passée.

8. Ensemble de panneau électrique (300) selon l'une quelconque des revendications 5 à 7, dans lequel l'au moins un poste d'assemblage comprend un bras (303) permettant de maintenir au moins l'un des connecteurs dudit faisceau de câbles électriques (105),
où ledit au moins un connecteur est mobile par utilisation du bras par rapport audit équipement de panneau électrique (103) du panneau électrique pour établir une relation visuelle alignée pour ledit ouvrier entre ledit au moins un connecteur et au moins l'un dudit équipement.

9. Ensemble de panneau électrique (300) selon l'une quelconque des revendications 5 à 8, dans lequel ledit bras est un bras robotique comportant un dispositif de préhension (306) à une extrémité pour maintenir ledit au moins un connecteur et des articulations de bras permettant un déplacement en rotation et/ou en translation de ladite extrémité dudit bras maintenant ledit au moins un connecteur.

10. Ensemble de panneau électrique (300) selon l'une quelconque des revendications 5 à 9, dans lequel ledit ensemble comprend en outre un robot configuré pour prendre un connecteur de la fixation de connecteur et monter le connecteur sur un équipement de panneau déterminé.

11. Procédé d'assemblage d'un panneau électrique (100) comportant un équipement de panneau électrique (103), ledit procédé comprenant les étapes de :
localisation de premières extrémités de câble (107) d'un faisceau de câbles électriques (105) dans un connecteur (201) dans des emplacements (210) correspondant aux emplacements finaux desdites premières extrémités de câble (107) dans le panneau électrique (100),
dans lequel le faisceau de câbles électriques (105) est préparé pour connecter un équipement de panneau électrique (103) d'un panneau électrique (100), le faisceau de câbles (105) comprenant :
une pluralité de câbles électriques (106) de dimensions différentes ayant de premières et secondes extrémités de câble (107, 108), et
un connecteur (201) avec des emplacements (210) permettant de fixer et de stocker une pluralité desdites premières extrémités de câble (107),
où les emplacements desdites premières extrémités de câble (107) dans ledit connecteur (201) correspondent aux emplacements finaux desdites premières extrémités de câble (107) dans le panneau électrique (100),
montage du panneau électrique (100) dans un ensemble de panneau électrique (300) selon l'une quelconque des revendications 5 à 10,
retrait d'une première extrémité d'un premier câble (107) d'un premier emplacement (210) du connecteur (201),
montage de la première extrémité du premier câble (107) dans la borne correspondante (101) du panneau électrique (100),
montage d'une seconde extrémité du premier câble (108) dans le panneau électrique (100), et montage des autres extrémités de câble du faisceau de câbles électriques (105) dans le panneau électrique.

12. Procédé selon la revendication 11, dans lequel le faisceau de câbles électriques (105) est créé par localisation des premières extrémités de câble (107) entre une première feuille et une seconde feuille d'une bande flexible, dans lequel la première feuille et la seconde feuille sont fixées l'une à l'autre entre les emplacements (210) des premières extrémités de câble (107) le long de la longueur de la bande flexible.

13. Procédé selon l'une quelconque des revendications 11 ou 12 précédentes, dans lequel le faisceau de câbles est établi sur la base d'une disposition de câbles électriques du panneau électrique, la disposition de câbles électriques étant conçue par un premier ouvrier et stockée dans un stockage de données communiquant avec un dispositif informatique,
dans lequel le faisceau de câbles est équipé d'une étiquette physique qui, lorsqu'elle est analysée à l'aide d'un scanneur, relie le faisceau de câbles physiques à la représentation numérique de la disposition de câbles électriques stockée dans le stockage de données,
dans lequel, lors de l'analyse de l'étiquette, la représentation numérique du faisceau de câbles électriques s'affiche pour un second ouvrier effectuant le montage du faisceau de câbles dans le panneau électrique, et
dans lequel l'affichage de la représentation numérique du faisceau de câbles électriques est réalisé de manière à afficher le tracé du câble à monter dans le panneau électrique.

14. Procédé selon l'une quelconque des revendications 11 à 13 précédentes, dans lequel le montage d'un faisceau de câbles comporte les étapes suivantes :
a) la mise en place d'un faisceau de câbles et d'un panneau électrique dans le poste d'assemblage,
b) l'analyse de l'étiquette du faisceau de câbles pour permettre au dispositif informatique d'afficher à l'écran la disposition de câble ou le tracé de câble d'un premier câble du faisceau de câbles dans le panneau électrique,
c) le montage de la première extrémité de câble et de la seconde extrémité de câble du premier câble sur l'équipement dans le panneau électrique selon la disposition de câble ou le tracé de câble,
d) lors du montage du premier câble, la fourniture au dispositif informatique de l'information selon laquelle le premier câble est monté, pour que le dispositif informatique affiche une disposition de câble ou un tracé de câble d'un second câble du faisceau de câbles sur l'écran,
e) la répétition de l'étape d) jusqu'à ce que tous les câbles du faisceau de câbles soient montés dans le panneau électrique, et
f) la fourniture au dispositif informatique de l'information selon laquelle le faisceau de câbles est entièrement monté.

15. Procédé selon l'une quelconque des revendications 11 à 14 précédentes, dans lequel le procédé comprend en outre les étapes de saisie dudit connecteur (201) à l'aide d'un bras et d'un dispositif de préhension d'un poste d'assemblage de l'ensemble de panneau électrique, et
de déplacement dudit connecteur (201) par utilisation du bras par rapport audit équipement de panneau électrique (103) du panneau électrique pour établir une relation alignée visuelle pour un ouvrier entre ledit connecteur (201) et au moins l'un dudit équipement de panneau (103).
